# Europäisches Patentamt
# European Patent Office
# Office européen des brevets

(19)

(11) Veröffentlichungsnummer: **0 010 227**
**B1**

(12) **EUROPÄISCHE PATENTSCHRIFT**

(45) Veröffentlichungstag der Patentschrift:
**25.11.81**

(21) Anmeldenummer: **79103785.6**

(22) Anmeldetag: **03.10.79**

(51) Int. Cl.³: **H 03 H 3/04,** H 03 H 9/13,
H 01 L 41/08

(54) **Piezoelektrischer Resonator.**

(30) Priorität: **20.10.78 DE 2845807**

(43) Veröffentlichungstag der Anmeldung:
**30.04.80 Patentblatt 80/9**

(45) Bekanntmachung des Hinweises auf die Patenterteilung:
**25.11.81 Patentblatt 81/47**

(84) Benannte Vertragsstaaten:
**AT BE CH DE FR GB IT NL SE**

(56) Entgegenhaltungen:
**DE-A-1 516 745**
**DE-B-1 466 166**
**GB-A-2 013 975**

(73) Patentinhaber: **SIEMENS AKTIENGESELLSCHAFT Berlin
und München, Postfach 22 02 61, D-8000 München 22 (DE)**

(72) Erfinder: **Mattuschka, Werner,
Johann-Clanze-Strasse 21, D-8000 München 70 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

## Piezoelektrischer Resonator

Die Erfindung bezieht sich auf einen piezoelektrischen Resonator mit einer dünnen Platte aus piezoelektrischem Material, die auf ihren großen Oberflächen jeweils mit mindestens einer Anregungselektrode versehen ist und neben den Anregungselektroden einen von diesen freien Bereich aufweist und bei dem wenigstens auf einer Seite des Resonators ein sich über die Anregungselektrode hinaus erstreckender Belag vorgesehen ist.

Ein solcher Resonator ist aus der DE-AS 1 516 745 bekannt. Bei diesem bekannten Resonator wird durch Aufdampfen der Anregungselektroden bewirkt, daß die Resonanzfrequenz des Dickenscherungsschwingers im mit Elektroden bedeckten Bereich des Resonators infolge der Elektrodenmasse nur den 0,8-fachen Wert der Resonanzfrequenz des Resonators in dem von Elektroden unbedeckten Bereich des Resonators hat. Auf diese Weise wird der aktive Bereich des Resonators, also der Bereich, in dem dieser im wesentlichen schwingt, auf den mit Elektroden bedeckten Bereich des Resonators konzentriert. Um beim Frequenzfeinabgleich des Resonators dieses günstige Verhältnis zwischen der Resonanzfrequenz im Elektrodenbereich und der Resonanzfrequenz im von den Elektroden unbedeckten Bereich des Resonators aufrechterhalten zu können ist ferner vorgesehen, einen zusätzlich zu den Anregungselektroden aufgebrachten Belag zumindest auf einer Seite des Resonators sich über die gesamte Fläche des Resonators auf dieser Seite erstrecken zu lassen. Auf diese Weise wird nämlich sowohl die Resonanzfrequenz im Elektrodenbereich als auch die Resonanzfrequenz in dem von den Elektroden unbedeckten Bereich des Resonators abgesenkt und damit das Verhältnis der Reso-nanzfrequenzen dieser Bereiche im wesentli-chen unverändert belassen. Für solche, sich über zumindest eine der großen Oberflächen des Resonators erstreckenden Beläge werden in der DE-AS 1 516 745 Stoffe genannt, die einen hohen Flächenwiderstand aufweisen, also z. B. Siliziummonoxyd oder eloxiertes also oxidiertes Aluminium oder oxidiertes Tantal, also Isolierstoffe mit hohem Q-Wert. Sonst würden nämlich die Anregungselektroden in unerwünschter Weise wieder vergrößert.

Das Aufbringen eines solchen Isolierstoffbelages ist jedoch technologisch relativ aufwendig und hat infolge von Alterungserscheinungen, Rekristallisationsvorgängen oder dergleichen zeitabhängig unerwünscht hohe Änderungen wichtiger Parameter des Resonators zur Folge.

Aufgabe der Erfindung ist es daher, einen Resonator der eingangs genannten Art so weiterzubilden, daß sich durch den zumindest auf einer Seite des Resonators vorgesehenen, sich über die Anregungselektroden hinaus erstreckenden Belag keine oder wenigstens nahezu keine durch Alterungsvorgänge od. dgl. verursachten Änderungen von wichtigen Resonatorparametern ergeben können, also ein Resonator mit großer zeitlicher Konstanz seiner Parameter erhalten werden kann.

Erfindungsgemäß ergibt sich die Lösung dieser Aufgabe dadurch, daß dieser Belag aus einer Metallschicht mit einer maximalen Dicke ($d_{max}$) in Nanometer von ungefähr $682/\sigma_x$ besteht, wobei $\sigma_x$ der spezifische Leitwert des verwendeten Metalls ist.

Vorliegender Erfindung liegt hierbei die Erkenntnis zugrunde, daß extrem dünne Metallschichten, die z. B. durch Aufdampfen relativ einfach auf piezoelektrischem Material niedergeschlagen werden können, Quasiisolatoren sind, d. h. einen so großen Flächenwiderstand aufweisen, daß ihre elektrische Leitfähigkeit sich nicht störend auswirken kann. Diese dünnen Metallschichten sind außerdem sehr alterungsbeständig, so daß aus solchen Metallschichten bestehende Beläge, die den Frequenzfeinab-gleich von Dickenscherungsschwingern bewir-ken, die Resonatorparameter auch nach langer Zeit nicht ungünstig verändern.

Weitere Ausgestaltungen der Erfindung sehen vor, daß als Metalle für den Belag Gold, Silber oder Aluminium vorgesehen sind, daß sich der zumindest auf einer Seite des Resonators vorgesehene Belag über die gesamte Oberfläche des Resonators erstreckt oder daß der zumindest auf einer Seite des Resonators vorgesehene Belag eine der randseitigen Angriffsfläche eines mit der Anregungselektrode der Gegenseite in Verbindung stehenden An-schlußorgans entsprechende Aussparung auf-weist und gegenüber einem Belag der Gegenseite isoliert ist.

Insbesondere die letztgenannte Maßnahme kann erforderlich sein, wenn besonders hohe Anforderungen an den Widerstand zwischen den Angriffspunkten der Anschlußorgane für den Resonator, die jeweils mit einer Anregungselektrode auf einer Seite des Resonators verbunden sind, gestellt werden.

Nachfolgend werden Ausführungsbeispiele der Erfindung anhand von zwei Figuren noch näher erläutert.

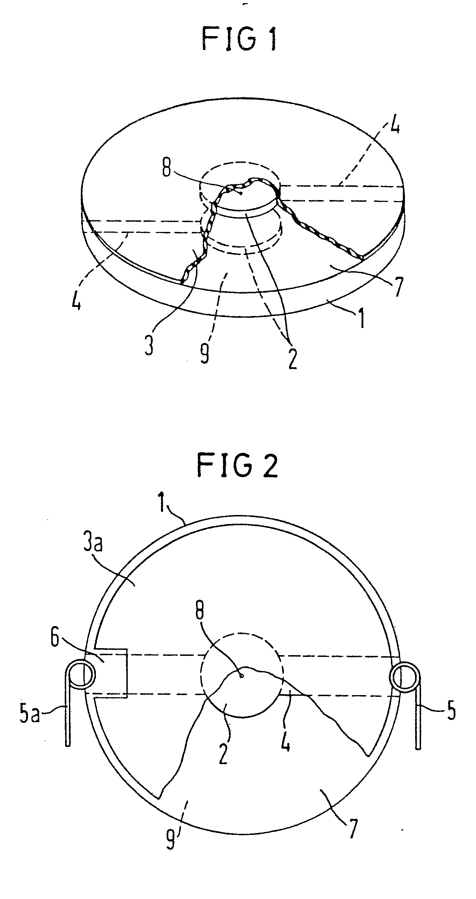

Dabei zeigen die Figuren jeweils stark vergrößert, in Schrägsicht (Fig. 1) und in Vorderansicht (Fig. 2), einen kreisscheibenförmigen Resonator 1, der als Dickenscherungsschwinger vorgesehen ist und auf seinen beiden großen Oberflächen 7 je eine konzentrisch zum Resonatormittel-punkt 8 angeordnete, ebenfalls kreisscheiben-förmige Anregungselektrode 2 trägt. Diese Anregungselektrode besteht in bekannter Weise aus einer dünnen auf den Resonator 1 aufgedampften Gold-, Silber- oder Aluminiumschicht, deren Dicke so gewählt ist, daß sie einen vernachlässigbar geringen Flächenwiderstand aufweist. Darüber hinaus ist Die Dicke der Anregungselektroden 2 so zu bestimmen, daß sich dadurch ein sogenanntes »energy trapping«, also eine Konzentration des aktiven Schwingbereichs des Resonators auf den Bereich der Anregungselektroden 2 des Resonators 1 ergibt, wobei noch anzumerken ist, daß sich die Anregungselektroden 2 der beiden großen Oberflächen 7 des Resonators decken müssen.

Durch die entsprechende Bemessung des Durchmessers der Anregungselektroden 2 gegenüber dem Durchmesser des kreisscheibenförmigen Resonators 1 wird ein von den Anregungselektroden unbedeckter kreisringförmiger Resonatorbereich 9 auf beiden Seiten des Resonators 1 erhalten. In diesem Bereich 9 ist der Resonator weitgehend schwingungsinaktiv, so daß der Resonator in den beiden Schnittpunkten eines Durchmessers mit seiner Peripherie von Halteorganen 5 und 5a erfaßt werden kann (Fig. 2), ohne daß damit seine Schwingeigenschaften nennenswert beeinträchtigt werden. Zur Verbindung je eines Anschlußorgans 5 bzw. 5a mit einer der beiden Anregungselektroden 2 sind streifenförmige Verbindungselektroden 4 vorgesehen, die sich auf jeder Seite des Resonators 1 von einer der Anregungselektroden 2 zu der Angriffsfläche eines der Anschlußorgane 5 bzw. 5a erstrecken und dabei entgegengesetzt zueinander gerichtet sind.

Der Frequenzfeinabgleich des Resonators wird beim Ausführungsbeispiel nach Fig. 1 durch einen die gesamte Oberfläche auf einer Seite des Resonators überziehenden Belag 3 bewirkt. Dieser Belag besteht aus einer extrem dünnen Metallschicht, wobei als Metalle besonders Gold, Silber oder Aluminium in Frage kommen. Experimentell hat sich ergeben, daß die maximale Dicke dieser Metallschicht den Wert von $682/\sigma_x$ in Nanometer nicht überschreiten darf, wobei $\sigma_x$ der spezifische Leitwert des verwendeten Metalls ist.

Setzt man für $\sigma_x$ z. B. den Wert 45,5 ein, dies ist der spezifische Leitwert von Gold, so erhält man eine maximale Schichtdicke für einen aus Gold bestehenden Belag 3 von 15 Nonometer. Für Silber ergibt sich eine maximale Dicke $d_{max}$ von ungefähr 11 Nanometer (spezifischer Leitwert von Silber 62,5) und für einen aus Aluminium bestehenden Belag eine maximale Dicke $d_{max}$ von ungefähr gleich 18,5 Nanometer (spezifischer Leitwert von Aluminium 37).

Metallschichten auf piezoelektrischen Körpern mit dieser maximalen Schichtdicke wirken, dies ist eine Erkenntnis der Erfindung, im Hinblick auf den angestrebten Verwendungszweck, genauso wie eine Schicht aus Isoliermaterial, d. h. ihr Flächenwiderstand ist so groß, daß er im Hinblick auf den sehr niedrigen Flächenwiderstand der Anregungselektroden keine unzulässige Vergrößerung der Anregungselektroden verursacht.

Trotz der geringen Dicke des Belages 3 lassen sich mit diesem beim Frequenzfeinabgleich noch relativ große Frequenzänderungen bewirken. Die Resonanzfrequenzen von Dickenscherungsschwingern liegen im Megaherzbereich. Zum Beispiel läßt sich unter Berücksichtigung der maximalen Dicke $d_{max}$ für den Belag 3 bei einer Resonanzfrequenz von 20 MHz (Grundschwingung) eine Frequenzänderung von maximal ca. 4 kHz bei Verwendung von Aluminium und bei Verwendung von Silber für den Belag 3 von maximal ungefähr 10 kHz und bei Verwendung von Gold eine solche von maximal ca. 26 kHz erzielen. Bei einer Schwingfrequenz (Resonanzfrequenz) von 25 MHz lauten die entsprechenden Werte 7 kHz, 16 kHz und 41 kHz. Bei Resonatoren, die mit dem 3. Oberton betrieben werden, ergeben sich maximal erzielbare Frequenzänderungen von ca. 4 kHz bei Aluminium, von ca. 8 kHz bei Silber und von ca. 20 kHz bei Gold bei einer Schwingfrequenz von 30 MHz. Bei einer Schwingfrequenz von 50 MHz (3. Oberton) sind die entsprechenden Werte ca. 9,21 und 55 kHz. Bei einer Schwingfrequenz von 75 MHz (3. Oberton) ca. 21,48 und 122 kHz. Alle diese Werte gelten für Resonatoren mit nur auf einer ihrer großen Oberflächen vorgesehenem Belag. Bei beidseitig vorgesehenem Belag verdoppeln sich diese Werte selbstverständlich.

Bei dem Ausführungsbeispiel entsprechend Fig. 2 ist der Belag 3a im Bereich der Angriffsfläche des Anschlußorgans 5, das mit der Anregungselektrode 2 auf der abgewandten Seite des Resonators 1 in Verbindung steht (über eine Verbindungselektrode 4), mit einer Aussparung 6 versehen, so daß in deren Bereich die Resonatoroberfläche 7 vom Belag 3 unbedeckt bleibt. Auf diese Weise wird bei besonders hohen Anforderungen bezüglich des Isolationswiderstandes zwischen den beiden Anschlußorganen 5 und 5a bzw. den beiden Anregungselektroden 2 des Resonators 1 eine wenn auch sehr hochohmige Verbindung der Anschlußorgane 5 und 5a über den Belag 3 vermieden. Eine solche Ausbildung des Belages 3 kommt jedoch nur für Anwendungsfälle in Betracht mit sehr hohen Anforderungen an den Widerstand zwischen den beiden Anschlußorganen 5 und 5a.

**Patentansprüche**

1. Piezoelektrischer Resonator mit einer dünnen Platte aus piezoelektrischem Material, die auf ihren großen Oberflächen jeweils mit mindestens einer Anregungselektrode versehen ist und neben den Anregungselektroden einen von diesen freien Bereich aufweist und bei dem wenigstens auf einer Seite des Resonators ein sich über die Anregungselektrode hinaus erstreckender Belag vorgesehen ist, dadurch gekennzeichnet, daß dieser Belag (3) aus einer Metallschicht mit einer maximalen Dicke ($d_{max}$) in Nanometer von ungefähr $682/\sigma_x$ besteht, wobei $\sigma_x$ der spezifische Leitwert des verwendeten Metalls ist.

2. Resonator nach Anspruch 1, dadurch gekennzeichnet, daß als Metalle für den Belag (3) Gold, Silber oder Aluminium vorgesehen sind.

3. Resonator nach einem der Ansprüche 1 oder 2, dadurch gekennzeichnet, daß sich der zumindest auf einer Seite des Resonators (1) vorgesehene Belag (3) über die gesamte Oberfläche des Resonators (1) erstreckt.

4. Resonator nach einem der Ansprüche 1 oder 2, dadurch gekennzeichnet, daß der zumindest auf einer Seite des Resonators (1) vorgesehene Belag (3) eine der randseitigen Angriffsfläche eines mit der Anregungselektrode (2) der Gegenseite in Verbindung stehenden Anschlußorgans (5) entsprechende Aussparung (6) aufweist und gegenüber einem Belag (3) der Gegenseite isoliert ist.

## Claims

1. A piezoelectric resonator comprising a thin plate of piezoelectric material whose large surfaces are each respectively provided with at least one excitation electrode but each, has a residual zone free of any electrodes, and wherein on at least one side of the resonator there is a coating which extends beyond the excitation electrode, characterised in that this coating (3) consists of a metal layer which has a maximal thickness $(d_{max})$ in nanometers of approximately $682/\sigma_x$, where $\sigma_x$ is the specific conductance of the metal used.

2. A resonator as claimed in Claim 1, characterised in that said metal layer is of gold, silver or aluminium.

3. A resonator as claimed in Claim 1 or Claim 2, characterised in that the coating (3) which is arranged on at least one side of the resonator (1) extends over the whole face of the resonator.

4. A resonator as claimed in Claim 1 or Claim 2, characterised in that the coating (3) which is arranged on at least one side of the resonator (1) has a recess (6) which matsches the boundary application suface of a terminal element (5) connected to the excitation electrode (2) of the opposite side, and is insulated from a coating (3) of the opposite side.

## Revendications

1. Résonateur piézoélectrique comportant une plaque mince en un matériau piézoélectrique, pourvu sur chacune de ses grandes surfaces d'au moins une électrode d'excitation et présentant près de cette électrode d'excitation une plage dégagée de celleci, du type dans lequel il est prévu, au moins sur un côté du résonateur, un revêtement s'étendant audelà des électrodes d'excitation, caractérisé par le fait que ce revêtement (3) est constitué par une couche métallique d'une épaisseur maximale $(d_{max})$ en nanomètres d'environ $682/\sigma_x$, $\sigma_x$ étant la conductance spécifique du métal ustilisé.

2. Résonateur selon la revendication 1, caractérisé par le fait que sont prévus comme métaux pour le revêtement (3), l'or, l'argent ou l'aluminium.

3. Résonateur selon l'une des revendications 1 ou 2, caractérisé par le fait que le revêtement (3) prévu au moins sur un côté du résonateur, s'étend sur la totalité de la surface de ce dernier.

4. Résonateur selon l'une des revendications 1 ou 2, caractérisé par le fait que le revêtement (3) est prévu sur au moins un côé du résonateur (1), et comporte un évidement (6) qui correspond à la surface d'attaque marginale d'un organe de raccordement (5) qui est en liaison avec l'électrode d'excitation (2) du côté opposé, et qu'il est isolé par rapport à un revêtement (3) situé du côté opposé.

# FIG 1

# FIG 2